# FASCICULE DE BREVET EUROPEEN

(11) **EP 1 940 019 B1**
(45) Date de publication et mention de la délivrance du brevet: **23.01.2013**
(21) Numéro de dépôt: 07123866.1
(22) Date de dépôt: 20.12.2007
(51) Int. Cl.: H03F 1/32, H03F 3/60

(54) **Dispositif de linéarisation à pré-distortion à amplitude et galbe réglables**
Vorrichtung zur Linearisierung durch Vorverzerrung mit regulierbarer Amplitude und regulierbarer Form
Linearisation device with pre-distortion with adjustable amplitude and curve

(30) Priorité: 28.12.2006 FR 0655991
(43) Date de publication de la demande: 02.07.2008
(73) Titulaire: THALES, 92200 Neuilly sur Seine (FR)
(72) Inventeur: Villemazet, Jean-François, 31550 Cintegabelle (FR); Maynard, Jean, 31520 Ramonville (FR); Geffroy, Dominique, 31490 Leguevin (FR)
(74) Mandataire: Esselin, Sophie

(56) Documents cités:
- EP-A- 1 039 630
- US-A- 4 109 212
- US-A- 5 172 068
- US-A- 5 966 049

## Description

L'invention concerne le domaine des dispositifs de linéarisation dits « à pré-distortion », qui sont par exemple utilisés en amont (ou en entrée) de dispositifs d'amplification de puissance de manière à compenser leur(s) non linéarité(s).

Comme le sait l'homme de l'art, un linéariseur est un dispositif qui permet de compenser la compression de gain (« AM/AM » pour « Amplitude-Amplitude Modulation conversion ») d'un amplificateur de puissance (par exemple de type HPA (pour « High Power Amplifier »)) ainsi que la variation de sa phase d'insertion en fonction de la puissance incidente (« AM/PM » pour « Amplitude-Phase Modulation conversion »). Les amplificateurs de puissance communément utilisés dans certains domaines, comme par exemple le domaine spatial, sont soit des amplificateurs dits à tube à onde progressive (ou TWTAs (pour « Travelling Wave Tube Amplifiers »), soit des amplificateurs dits à état solide (ou SSPAs (pour « Solid State Power Amplifiers »)).

Le principe de linéarisation généralement utilisé dans les charges utiles de satellites, est la prédistorsion. Un linéariseur à prédistorsion est un dispositif que l'on place en amont de l'entrée d'un amplificateur de puissance. Il doit présenter une réponse en gain et en phase en fonction de sa puissance de sortie qui est l'inverse de celle de l'amplificateur de puissance (en fonction de sa puissance d'entrée) auquel il doit être couplé, d'une première part en terme de sens de variation (expansion de gain au lieu de compression de gain), d'une deuxième part en terme d'amplitude de variation (par exemple +7dB d'expansion de gain et +40 degrés d'expansion de phase en présence d'un amplificateur présentant une compression à saturation de -7dB et de - 40 degrés), et d'une troisième part en terme de forme de caractéristique (également appelée « galbe ») de façon à « épouser » toute la caractéristique de l'amplificateur et donc de linéariser toute sa dynamique pour prendre en compte les variations de puissance d'entrée et d'enveloppe du signal utile (pour le réglage du linéariseur on raisonne avec un signal mono-porteuse (CW) mais le signal utile est porteur d'une modulation et est, le plus généralement, à enveloppe non constante).

Il est possible de régler l'amplitude des extensions de gain et de phase d'un linéariseur à prédistorsion de sorte que sa réponse soit adaptée à un amplificateur de puissance à linéariser. Malheureusement, les galbes de compression et d'expansion du linéariseur et de l'amplificateur associé ne sont, dans la plupart des cas, pas identiques, et donc la linéarisation est imparfaite. Par exemple, si le linéariseur présente une expansion de gain lente (c'est-à-dire proche d'une droite) alors que la compression de l'amplificateur est relativement brutale (c'est-à-dire proche d'une fonction exponentielle), le réglage du linéariseur, qui correspond à une compensation totale à saturation de l'amplificateur, conduit à une forte sur-compensation en recul pour les puissances d'entrée qui sont inférieures à la saturation, ce qui dégrade globalement la linéarité sur l'ensemble de la dynamique de puissance de l'amplificateur linéarisé. Dans ce cas, le réglage optimal est obtenu en ne compensant pas toute la compression de l'amplificateur afin de ne pas faire trop de sur-compensation en recul.

La plupart des linéariseurs à prédistorsion utilisent des éléments non linéaires tels que des diodes Schottky. Le comportement non linéaire en transmission du linéariseur en fonction de sa puissance d'entrée est alors basé sur un mécanisme dit d'auto-polarisation de la diode en présence d'un signal RF de fort niveau de puissance. L'évolution du point de polarisation en fonction de la puissance RF va en effet induire un comportement particulier de la diode en terme d'impédance présentée au signal RF incident. Deux principaux types de polarisation de la diode peuvent conduire à des comportements d'auto-polarisation non linéaires différents selon que la diode est alimentée par un générateur de tension à travers une résistance de grande valeur ou de petite valeur montée en série.

En cas de polarisation à travers une résistance (R) de grande valeur, lorsque la puissance du signal RF d'entrée augmente, le courant (I_{D}) qui alimente la diode augmente et donc la tension V_{D} aux bornes de cette diode diminue (VD = V_{LIN} - RI_{D}, V_{LIN} étant la tension d'alimentation du linéariseur).

Par conséquent, le courant qui traverse la diode est sensiblement constant.

En cas de polarisation à travers une résistance (R) de faible valeur, lorsque la puissance du signal RF d'entrée augmente, le courant qui traverse la diode augmente du fait que la tension V_{D} aux bornes de cette diode est sensiblement constante (VD ≈V_{LIN}).

La diode est alors utilisée comme une impédance qui varie en fonction de la puissance RF d'entrée dans un circuit de linéarisation, chargé de transformer cette variation d'impédance en variation des paramètres de transmission du dispositif dont il fait partie. La (ou les) diode(s) peu(ven)t ainsi être utilisée(s) en réflexion comme charge d'un coupleur hybride, ou en transmission sur une ligne de propagation, ou encore en configuration série ou parallèle, par exemple.

De nombreux dispositifs mettant en oeuvre le mécanisme non linéaire d'auto-polarisation classique (décrit ci-avant) ont été proposés. Ils sont par exemple décrits dans les documents brevet US 4,992,754, US 4,068,186, FR 2 719 954, FR 2 791 197 , FR 2 833 431et EP 1,039,630.

Malheureusement, ce mécanisme non linéaire d'auto-polarisation classique conduit invariablement à un seul et même type de courbure des expansions de gain et de phase du linéariseur et ne permet donc pas de contrôler le galbe (la forme) des expansions.

L'invention a donc pour but de permettre le contrôle du galbe des expansions d'un linéariseur à pré-distortion afin d'améliorer significativement la linéarisation des amplificateurs de puissance sur toute leur dynamique.

Elle propose à cet effet un dispositif de linéarisation à pré-distortion à expansions de gain et de phase pour la compensation de la compression de gain et de la variation de phase d'un amplificateur de puissance.

Ce dispositif de linéarisation se caractérise par le fait qu'il comprend :
- des premiers moyens de division comprenant une entrée propre à recevoir un signal d'entrée hyperfréquence et des première et seconde sorties chargées de délivrer des première et seconde fractions choisies, préférentiellement ajustables, du signal d'entrée,
- une première voie connectée à la première sortie afin d'être alimentée par la première fraction du signal d'entrée, et agencée pour générer un premier courant continu à partir d'une première auto-polarisation d'une première diode en fonction de la première fraction du signal d'entrée,
- une seconde voie connectée à la seconde sortie afin d'être alimentée par la seconde fraction du signal d'entrée, et chargée de réaliser des expansions de gain et de phase au niveau d'un accès constituant une sortie (de la seconde voie et du dispositif de linéarisation) à partir d'une seconde auto-polarisation d'au moins une seconde diode en fonction de la seconde fraction du signal d'entrée, et
- un circuit de polarisation connecté aux, et alimentant en tensions continues, les première et seconde voies, et chargé de combiner, de manière antagoniste, les tensions et courants continus issus des première et seconde auto-polarisations des première et seconde voies de manière à contrôler le galbe des expansions de gain et de phase de la seconde voie en fonction de l'amplitude du signal d'entrée.

Le dispositif de linéarisation selon l'invention peut comporter d'autres caractéristiques qui peuvent être prises séparément ou en combinaison, et notamment :
- sa première voie peut comprendre un premier circuit connecté à la première sortie des premiers moyens de division et chargé d'alimenter au moins une première diode avec la première fraction du signal d'entrée et de fournir deux accès isolés vis-à-vis de la première fraction du signal d'entrée et permettant d'appliquer directement des tensions continues respectivement aux bornes de la première diode ;
- sa seconde voie peut comprendre un second circuit connecté à la seconde sortie des premiers moyens de division et chargé, d'une part, d'alimenter au moins une seconde diode avec une partie au moins de la seconde fraction du signal d'entrée afin de transformer une variation d'impédance de la seconde diode en fonction de la seconde fraction du signal d'entrée en expansions de gain et de phase au niveau d'un accès définissant une sortie (de la seconde voie et du dispositif de linéarisation), et d'autre part, de fournir deux autres accès isolés vis-à-vis de la seconde fraction du signal d'entrée et permettant d'appliquer directement des tensions continues respectivement aux bornes de la seconde diode ;
- son circuit de polarisation peut comprendre un premier générateur de tension continue connecté à l'anode de la première diode à travers l'un des accès de la première voie, un second générateur de tension continue connecté simultanément à travers une résistance à un noeud commun constitué de la cathode de la première diode à travers l'autre des accès de la première voie et de l'anode de la seconde diode à travers l'un des accès de la seconde voie, la cathode de la seconde diode étant reliée, à travers l'autre des accès de la seconde voie, à la masse du point de vue de la tension continue;
- le sens des première et seconde diodes peut être simultanément inversé ;
- ses premiers moyens de division peuvent comprendre un coupleur chargé de diviser la puissance du signal d'entrée en deux parties, et un élément placé en aval de l'une au moins des deux sorties du coupleur et chargé d'amplifier ou d'atténuer d'une quantité choisie et réglable la valeur de la puissance délivrée par chacune des deux sorties du coupleur, de sorte que les premiers moyens de division délivrent sur des première et seconde sorties respectivement les première et seconde fractions choisies, ajustables, du signal d'entrée ;
   ➢ l'élément peut par exemple être choisi dans un groupe comprenant un élément atténuateur variable, un élément amplificateur, un élément amplificateur à gain variable, et un élément associant en cascade plusieurs des fonctions des autres éléments de ce groupe ;
   ➢ l'élément peut présenter un comportement non uniforme et réglable en fonction de la fréquence ;
- le second circuit peut constituer un circuit de linéarisation à base de diode(s) dont les accès de polarisation continue ne comportent pas de résistance en série avec cette ou ces diodes ;
   ➢ le circuit de linéarisation peut comprendre :
      - des seconds moyens de division comprenant une entrée connectée à la seconde sortie des premiers moyens de division et des première et seconde sorties chargées de délivrer des première et seconde sous-fractions choisies de la seconde fraction du signal d'entrée,
      - des moyens de combinaison comprenant des première et seconde entrées et une sortie propre à délivrer des signaux de sortie résultant de la combinaison des signaux reçus sur ses première et seconde entrées,
      - une première sous-voie dite non linéaire comportant un premier coupleur (préférentiellement de type coupleur de Lange) comprenant des premier et deuxième accès connectés chacun à la masse via au moins une seconde diode alimentée en tension et courant continus par le second générateur à travers la résistance au noeud (point) commun, un troisième accès connecté à la première sortie des seconds moyens de division, et un quatrième accès couplé à la première entrée des moyens de combinaison, et
      - une seconde sous-voie dite linéaire comportant un second coupleur sensiblement identique au premier coupleur afin d'assurer par construction un même temps de propagation de groupe pour les première et seconde sous-voies et comprenant des premier et deuxième accès connectés chacun à la masse via des troisièmes composants passifs, un troisième accès connecté à la seconde sortie des seconds moyens de division, et un quatrième accès couplé à la seconde entrée des moyens de combinaison ;
         o les troisièmes composants passifs peuvent être des tronçons de ligne de transmission hyperfréquence en circuit ouvert, de longueur et largeur ajustables de manière à ajuster la phase de combinaison des signaux dans les moyens de combinaison, de façon sensiblement constante sur toute une bande de fréquences choisie ;
         o l'une au moins des première et seconde sous-voies peut comporter une ligne de transmission de longueur réglable, de manière à modifier le temps de propagation de groupe de sa sous-voie pour régler la phase de combinaison des signaux dans les moyens de combinaison, de façon non constante en fonction de la fréquence, de sorte que le linéariseur présente un comportement différent en fonction de la fréquence sur une large bande de fréquences de manière à suivre des variations fréquentielles de l'amplificateur de puissance à linéariser ;
         o l'une au moins des première et seconde sous-voies peut comporter au moins une résistance gravée en série ou en parallèle sur la ligne de transmission jouant le rôle d'atténuateur de valeur d'atténuation réglable entre une valeur finie et zéro par court-circuit de la résistance en série au moyen d'un ruban ou d'au moins un fil métallique et par rupture du ou des rubans ou fils de connexion reliant la résistance en parallèle, à la ligne de transmission ;
   - le premier circuit peut comprendre des éléments de circuit chargés d'adapter l'impédance de la première diode par rapport à la première sortie des premiers moyens de division et de permettre la polarisation des bornes de la première diode sans résistance en série sur l'une ou l'autre de ces bornes ;
   - le premier circuit peut comprendre des circuits de polarisation en quart de longueur d'onde comportant une première ligne de transmission d'impédance caractéristique élevée (par rapport à 50Ω), de longueur égale au quart de la longueur d'onde, dont une première extrémité est connectée à la ligne alimentant la première diode et une seconde extrémité est connectée, d'une part, à une seconde ligne de transmission d'impédance caractéristique faible (par rapport à 50Ω), de longueur égale au quart de la longueur d'onde, et terminée par un circuit ouvert, et d'autre part, à l'un des accès de polarisation du premier circuit ;
   - le premier circuit peut comprendre plusieurs circuits de polarisation en quart de longueur d'onde cascadés de manière à augmenter l'isolation des accès de polarisation du premier circuit par rapport à la première fraction du signal d'entrée.

L'invention propose également un dispositif d'amplification de puissance à état solide équipé d'un dispositif de linéarisation à pré-distortion du type de celui présenté ci-avant.

De par son principe basé sur un mécanisme d'auto-polarisation modifié à deux diodes (tension et courant continus), l'invention est compatible avec un fonctionnement sur une large bande de fréquences.

D'autres caractéristiques et avantages de l'invention apparaîtront à l'examen de la description détaillée ci-après, et des dessins annexés, sur lesquels :
- la figure 1 illustre de façon très schématique une association d'un dispositif de linéarisation selon l'invention et d'un dispositif d'amplification, par exemple de type TOP (Tube à Onde Progressive),
- la figure 2 illustre de façon très schématique un dispositif d'amplification selon l'invention, par exemple de type amplificateur de puissance à état solide, intégrant un dispositif de linéarisation,
- la figure 3 illustre de façon schématique et fonctionnelle un premier exemple de réalisation d'un dispositif de linéarisation selon l'invention,
- la figure 4 illustre le schéma électrique en tension et courant continu (DC) équivalant au dispositif de linéarisation de la figure 3,
- la figure 5 est un diagramme illustrant un exemple de caractéristique courant/tension de la première diode (D1) de la première voie du dispositif de linéarisation de la figure 3,
- la figure 6 est un diagramme illustrant un exemple de caractéristique courant/tension de la seconde diode (D2) de la seconde voie du dispositif de linéarisation de la figure 3,
- la figure 7 est un diagramme illustrant un exemple d'évolution de la tension aux bornes de la seconde diode (D2) de la seconde voie du dispositif de linéarisation de la figure 3, en fonction de la puissance de la seconde fraction du signal d'entrée, pour différentes valeurs du rapport entre les puissances des première et seconde fractions du signal d'entrée,
- la figure 8 est un diagramme illustrant un exemple d'évolution du module de l'impédance aux bornes d'une seconde diode (D2) de la seconde voie du dispositif de linéarisation de la figure 3, en fonction de la puissance de la seconde fraction du signal d'entrée, pour différentes valeurs du rapport entre les puissances des première et seconde fractions du signal d'entrée,
- la figure 9 est un diagramme illustrant un exemple d'évolution de l'expansion du gain en fonction de la puissance de la seconde fraction du signal d'entrée, pour différentes valeurs du rapport entre les puissances des première et seconde fractions du signal d'entrée,
- la figure 10 illustre le schéma électrique équivalant à un exemple de réalisation de la première voie du dispositif de linéarisation de la figure 3,
- la figure 11 illustre le schéma électrique équivalant à un second exemple de réalisation de la première voie du dispositif de linéarisation de la figure 3, et
- la figure 12 illustre de façon schématique et fonctionnelle un exemple de réalisation de la seconde voie d'un dispositif de linéarisation selon l'invention.

Les dessins annexés pourront non seulement servir à compléter l'invention, mais aussi contribuer à sa définition, le cas échéant.

L'invention a pour objet de proposer un dispositif de linéarisation (ou linéariseur) à pré-distortion D chargé de réaliser des expansions de gain et de phase de forme (ou allure ou encore galbe - « shape » en anglais) et d'amplitude réglables en fonction d'un signal hyperfréquence d'entrée.

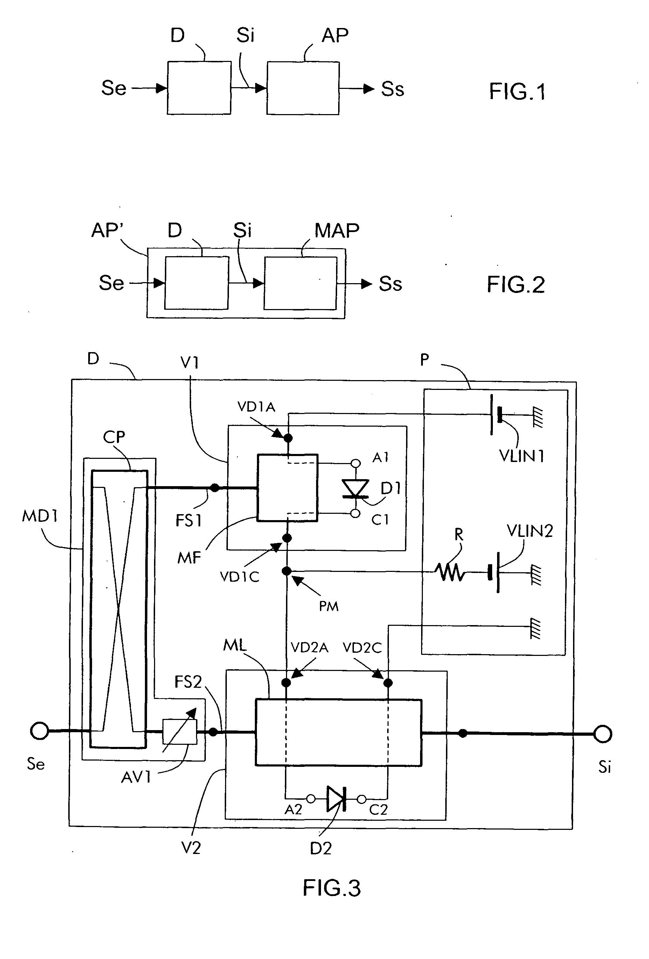

Comme cela est très schématiquement illustré sur la figure 1, un linéariseur D selon l'invention peut par exemple être un équipement destiné à être connecté en amont de l'entrée d'un dispositif d'amplification AP (ci-après appelé amplificateur), par exemple de type TOP (Tube à Onde Progressive ou TWTA (pour « Travelling Wave Tube Amplifier »)) ou de type « état solide » (ou SSPAs (pour « Solid State Power Amplifiers »). Mais, dans une variante illustrée schématiquement sur la figure 2, un linéariseur D selon l'invention peut constituer une partie d'un dispositif d'amplification AP' (ci-après appelé amplificateur linéarisé), par exemple de type amplificateur de puissance à état solide. Dans ce cas, l'amplificateur AP' comprend également un module d'amplification MAP en amont duquel est connecté un linéariseur D selon l'invention.

L'amplificateur AP ou AP' peut par exemple être destiné à amplifier un canal dans la section de sortie d'un satellite de télécommunication. Dans ce cas, les signaux hyperfréquences des différents canaux sont généralement amplifiés séparément avant d'être multiplexés.

Par ailleurs, l'amplificateur AP et le linéariseur D associé, ou bien l'amplificateur linéarisé AP', peu(ven)t faire partie d'un équipement appelé MPM (pour « Microwave Power Module »), conjointement avec un générateur de tension/courant continus (ou EPC pour « Electronic Power Conditioner »).

Par convention, on appelle dans ce qui suit, d'une première part, « signal d'entrée Se » un signal électronique hyperfréquence (RF), numérique ou analogique, qui alimente l'entrée d'un linéariseur D selon l'invention, d'une deuxième part, « signal intermédiaire Si » un signal électronique hyperfréquence (RF) délivré en sortie d'un linéariseur (dispositif de linéarisation) D selon l'invention et alimentant l'entrée d'un amplificateur AP ou d'un module d'amplification MAP d'un amplificateur linéarisé AP', et d'une troisième part, « signal de sortie Ss » un signal électronique hyperfréquence (RF) délivré en sortie d'un amplificateur AP ou d'un module d'amplification MAP d'un amplificateur linéarisé AP'.

Dans ce qui suit, on considère à titre d'exemple non limitatif que le linéariseur D est connecté à un amplificateur AP, comme illustré sur la figure 1.

Comme cela est schématiquement et fonctionnellement illustré sur la figure 3, un linéariseur D selon l'invention comprend au moins un premier module de division MD1, des première V1 et seconde V2 voies, et un circuit de polarisation P.

On notera que sur les figures 3, 10, 11 et 12, les traits épais matérialisent les trajets empruntés par les signaux hyperfréquences, tandis que les traits fins matérialisent les trajets empruntés par les courants continus.

Le premier module de division MD1 est chargé de diviser (ou séparer) un signal d'entrée hyperfréquence (RF) Se qu'il reçoit sur une entrée en des première FS1 et seconde FS2 fractions qu'il délivre respectivement sur des première et seconde sorties. Les valeurs complémentaires de ces première FS1 et seconde FS2 fractions sont ajustables en fonction des besoins. Comme on le verra plus loin, ces valeurs permettent de fixer partiellement les allures (ou formes ou galbes) et amplitudes des courbes d'expansion de gain et de phase du linéariseur D.

Comme cela est illustré sur la figure 3, le premier module de division MD1 peut par exemple être constitué d'un coupleur 1x2 CP (éventuellement de type 3dB/3dB, soit 50%/50%), chargé de diviser la puissance du signal d'entrée Se en deux parties sensiblement égales, et d'un atténuateur variable AV1 placé en aval de l'une au moins des deux sorties du coupleur CP et chargé de diminuer d'une quantité choisie (éventuellement réglable) la valeur de la puissance délivrée par cette sortie de coupleur CP. Ainsi, le premier module de division MD1 délivre sur des première et seconde sorties respectivement des première FS1 et seconde FS2 fractions différentes (ici FS1 > FS2).

On notera que le premier module de division MD1 peut être agencé sous des formes différentes de celle illustrée de façon non limitative. Ainsi, l'atténuateur variable AV1 peut être réalisé à partir d'éléments actifs tels que des amplificateurs cascadés avec des atténuateurs commandables, ou directement à partir d'amplificateurs à gain variable. L'atténuateur variable AV1 peut également avoir un comportement non uniforme et réglable en fonction de la fréquence.

La première voie V1 est connectée à la première sortie du premier module de division MD1, afin d'être alimentée par la première fraction FS1 du signal d'entrée Se. Elle est chargée de générer un premier courant continu à partir d'une première auto-polarisation d'une première diode D1 en fonction de la première fraction FS1 du signal d'entrée Se.

La seconde voie V2 est connectée à la seconde sortie du premier module de division MD1, afin d'être alimentée par la seconde fraction FS2 du signal d'entrée Se. Elle est chargée de réaliser des expansions de gain et de phase au niveau d'un accès (Si) constituant la sortie de la seconde voie V2 et du dispositif D à partir d'une seconde auto-polarisation d'au moins une seconde diode D2 en fonction de la seconde fraction FS2 du signal d'entrée Se.

Le circuit de polarisation P est connecté et alimente en tensions continues les première V1 et seconde V2 voies. Il permet de combiner en un même circuit, de manière antagoniste, les tensions et courants continus issus des première et seconde auto-polarisations des première V1 et seconde V2 voies de façon à contrôler le galbe des expansions de gain et de phase de la seconde voie V2 en fonction de l'amplitude du signal d'entrée Se.

Le circuit de polarisation P comprend un premier générateur de tension continue G1 chargé de délivrer une première tension d'alimentation continue VLIN1, une résistance R et un second générateur de tension continue G2 chargé de délivrer une seconde tension d'alimentation continue VLIN2.

Dans l'exemple illustré sur la figure 3, la première voie V1 comprend au moins une première diode D1 et un premier circuit MF.

Le premier circuit MF est chargé d'alimenter au moins une première diode D1 avec la première fraction FS1 du signal d'entrée Se, tout en fournissant deux accès VD1A et VD1C isolés vis-à-vis de cette première fraction du FS1 signal d'entrée Se et permettant d'appliquer directement des tensions continues respectivement aux bornes A1 et C1 de la première diode D1.

Dans l'exemple illustré sur la figure 3, la seconde voie V2 comprend au moins une seconde diode D2 et un second circuit ML.

Le second circuit ML est chargé d'alimenter au moins une seconde diode D2 avec tout ou partie de la seconde fraction FS2 du signal d'entrée Se afin de transformer la variation d'impédance de cette seconde diode D2 en fonction de cette seconde fraction FS2 du signal d'entrée Se en expansions de gain et de phase au niveau de l'accès (Si) qui constitue la sortie de la seconde voie V2 et du dispositif D tout en fournissant deux autres accès VD2A et VD2C isolés vis-à-vis de la seconde fraction FS2 du signal d'entrée Se et permettant d'appliquer directement des tensions continues respectivement aux bornes A2 et C2 de la seconde diode D2.

Dans l'exemple illustré sur la figure 3, le premier générateur de tension continue G1 (du circuit de polarisation P) est connecté à la borne A1 de la première diode D1 à travers l'accès VD1A, et le second générateur de tension continue G2 (du circuit de polarisation P) est connecté simultanément à travers la résistance R (qui présente une grande valeur (typiquement d'environ 250 Ω à 5 KΩ)) à un noeud commun PM constitué de la borne C1 de la première diode D1 à travers l'accès VD1C et de la borne A2 de la seconde diode D2 à travers l'accès VD2A. La borne C2 de la seconde diode D2 est reliée à travers l'accès VD2C à la masse du point de vue de la tension continue en même temps que sa mise à la masse du point de vue hyperfréquence.

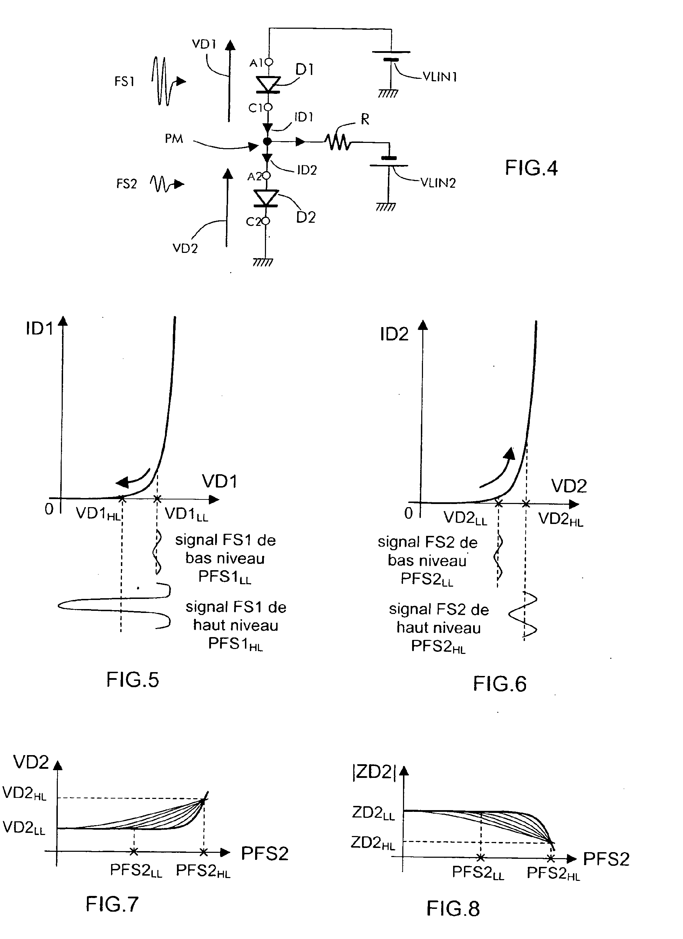

Du fait du montage présenté ci-avant, la diode D2 est polarisée de sorte qu'en cas d'augmentation de la puissance de la seconde fraction FS2 du signal d'entrée Se le courant ID2 qu'elle génère croisse. Si l'on se réfère au schéma électrique de la figure 4, qui est l'équivalent en tension et courant continus (DC) du schéma de la figure 3, on comprend que la tension de commande VD2 est donnée par la formule VD2 = R*(ID1 - ID2) - VLIN2. L'augmentation du courant ID2 entraîne donc une réduction de la part du courant ID1 qui traverse la résistance R. Par conséquent, lorsque le courant ID2 augmente, la tension de commande VD2 est réduite de façon contrôlée sous l'action de l'auto-polarisation de la diode D1. Les diodes D1 et D2 apportent donc des contributions antagonistes au mécanisme d'auto-polarisation, si bien que l'on peut qualifier ce dernier de « dual ».

Lorsque la puissance PFS1 de la première fraction FS1 du signal d'entrée Se est supérieure à celle PFS2 de la seconde fraction FS2 du signal d'entrée Se (PFS1 > PFS2), alors le courant continu ID1 sortant de la première diode ID1 est supérieur au courant continu ID2 sortant de la seconde diode D2 (ID1 > ID2). Le courant continu ID1 passe principalement dans la résistance R. Lorsque le courant continu ID2 augmente du fait que la puissance PFS2 augmente, une partie du courant ID1 se dirige vers la seconde voie V2 au lieu d'aller vers la résistance R, permettant ainsi de réduire l'auto-polarisation de la première diode D1, donc de réduire l'augmentation de la tension VD2 aux bornes de la seconde diode D2 en fonction de l'augmentation de la puissance PFS2, donc de modifier le comportement hyperfréquence de la seconde diode D2 en fonction de cette puissance PFS2, et donc de contrôler la variation des expansions de gain et de phase de la seconde voie V2 en fonction de ladite puissance PFS2.

On a représenté schématiquement sur la figure 5, un diagramme illustrant un exemple de caractéristique courant (ID1) / tension (VD1) de la première diode D1. La tension VD1_{HL} représente la valeur de la tension continue aux bornes de la première diode D1 lorsque le signal hyperfréquence FS1 est de haut niveau (c'est-à-dire lorsque sa puissance est maximale (PFS1_{HL})), tandis que la tension VD1_{LL} représente la valeur de la tension continue aux bornes de la première diode D1 lorsque le signal hyperfréquence FS1 est de bas niveau (c'est-à-dire lorsque sa puissance est minimale (PFS1_{LL})). Comme l'indique la flèche, on vérifie bien sur l'exemple illustré que, sous l'action du mécanisme d'auto-polarisation, la tension continue VD1 aux bornes de la première diode D1 décroît lorsque le courant continu ID1 croît, c'est-à-dire lorsque la première fraction FS1 du signal d'entrée Se croît.

On a représenté schématiquement sur la figure 6, un diagramme illustrant un exemple de caractéristique courant (ID2) / tension (VD2) de la seconde diode D2. La tension VD2_{HL} représente la valeur de la tension continue aux bornes de la seconde diode D2 lorsque le signal hyperfréquence FS2 est de haut niveau (c'est-à-dire lorsque sa puissance est maximale (PFS2_{HL})), tandis que la tension VD2_{LL} représente la valeur de la tension continue aux bornes de la seconde diode D2 lorsque le signal hyperfréquence FS2 est de bas niveau (c'est-à-dire lorsque sa puissance est minimale (PFS2_{LL})). Comme l'indique la flèche, on vérifie bien sur l'exemple illustré que, sous l'action du mécanisme d'auto-polarisation duale, la tension continue VD2 aux bornes de la seconde diode D2 croît lorsque le courant continu ID2 croît, c'est-à-dire lorsque la seconde fraction FS2 du signal d'entrée Se croît. Il est important de noter que les diagrammes illustrés sur les figures 5 et 6 sont corrélés en temps réel.

On a représenté schématiquement sur la figure 7, un diagramme illustrant un exemple d'évolution de la tension de commande VD2 en fonction de la puissance PFS2 de la seconde fraction FS2 du signal d'entrée Se, pour différentes valeurs du rapport entre les puissances PFS1 et PFS2 des première FS1 et seconde FS2 fractions du signal d'entrée Se (et pour des tensions de commande VLIN1 et VLIN2 constantes). Comme on peut le constater, en réglant la valeur du rapport PFS1/PFS2 on modifie l'allure de la courbe d'évolution de la tension VD2 en fonction de la puissance PFS2.

On a également représenté schématiquement sur la figure 8, un diagramme illustrant un exemple d'évolution du module de l'impédance ZD2 présentée en hyperfréquence par la seconde diode D2 en fonction de la puissance PFS2 de la seconde fraction FS2 du signal d'entrée Se, pour différentes valeurs du rapport entre les puissances PFS1 et PFS2 des première FS1 et seconde FS2 fractions du signal d'entrée Se (et pour des tensions de commande VLIN1 et VLIN2 constantes). Le module de l'impédance ZD2 variant de façon sensiblement opposée à la tension continue VD2, on peut donc constater qu'en réglant la valeur du rapport PFS1/PFS2 on modifie l'allure de la courbe d'évolution de l'impédance ZD2 en fonction de la puissance PFS2. Ces modifications d'allure induisent alors des modifications de même type des allures (ou formes ou galbes) et amplitudes des courbes d'expansion de gain et de phase du linéariseur D.

Il est important de noter que les diagrammes illustrés sur les figures 7 et 8 sont une conséquence en temps réel de l'exemple d'évolution illustré sur les figures 5 et 6. Par ailleurs, il est également important de noter que les diagrammes illustrés sur les figures 5, 6, 7 et 8 traduisent un même phénomène non linéaire à trois endroits différents du dispositif D.

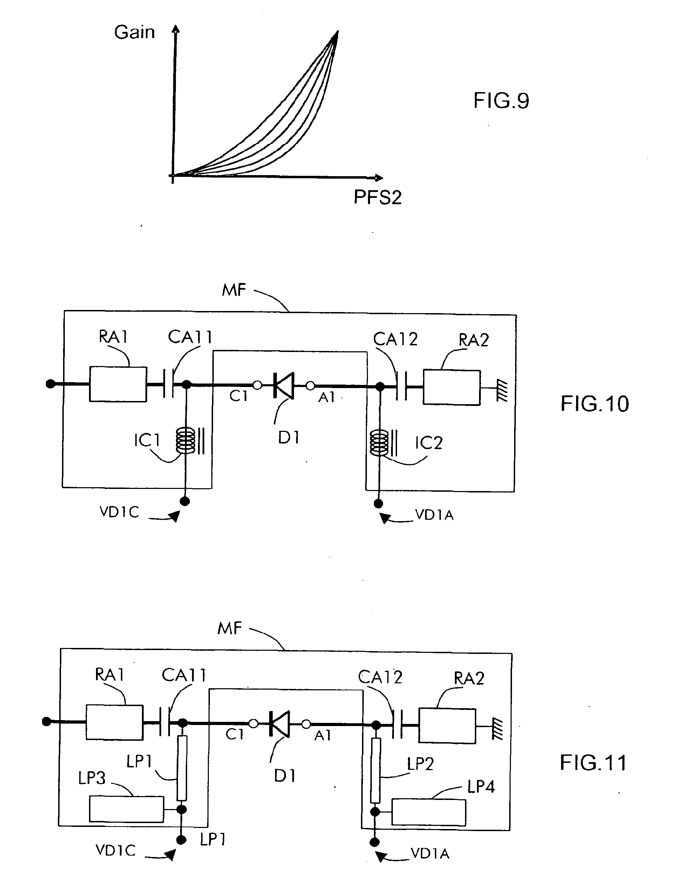

Un exemple d'évolution de la forme (ou galbe) de l'extension du gain en fonction de la puissance PFS2 de la seconde fraction FS2 du signal d'entrée Se, pour différentes valeurs du rapport entre les puissances PFS1 et PFS2 des première FS1 et seconde FS2 fractions du signal d'entrée Se (et pour des tensions de commande VLIN1 et VLIN2 constantes), est schématiquement illustré sur la figure 9. Le même type d'évolution peut être tracé pour l'expansion de phase en fonction de la puissance PFS2 de la seconde fraction FS2 du signal d'entrée Se. Il est important de noter que le diagramme illustré sur la figure 9 est une conséquence des exemples d'évolution illustrés sur les figures 5 à 8.

En résumé, le réglage de la forme (du galbe) des expansions de gain et de phase du dispositif D en fonction de la puissance Pse du signal d'entrée Se alimentant le premier module de division MD1 est opéré suivant deux paramètres :
- le ratio (PFS1/PFS2) des puissances des première FS1 et seconde FS2 fractions de signal d'entrée Se : plus la puissance incidente sur l'une des deux diodes D1 et D2 est élevée, plus le courant continu généré par cette diode est élevé, et plus sa contribution est forte,
- les valeurs des tensions continues VLIN1 et VLIN2: typiquement, le paramètre VLIN1+VLIN2 (avec l'orientation du second générateur G2 illustrée sur la figure 3) favorise la contribution de la première diode D1 lorsque VLIN1+VLIN2 est de faible valeur, conduisant à des caractéristiques de gain (Gain = f(PSe)) et de phase (Phase = f(PSe)) croissantes de type quadratique. A l'inverse, pour une valeur du paramètre VLIN1+VLIN2 plus forte, c'est la contribution de la seconde diode D2 qui devient prépondérante, les caractéristiques de gain (Gain = f(PSe)) et de phase (Phase = f(PSe)) se tendent et deviennent plus de type exponentiel, la diode D2 s'opposant pour les faibles valeurs de puissance d'entrée PSe à l'augmentation de la tension de commande VD2.

Du fait de ce comportement offert par le schéma électrique d'auto-polarisation duale illustré sur la figure 4, le dispositif de linéarisation D, selon l'invention, peut être utilisé en tant que circuit de linéarisation à pré-distortion à galbe variable.

Dans l'exemple non limitatif de la figure 10, les premiers moyens de connexion MF comprennent des premiers CA11 et second CA12 éléments capacitifs de liaison, des premier IC1 et second IC2 éléments inductifs de choc, et des premier RA1 et second RA2 circuits d'adaptation d'impédance.

Le premier circuit d'adaptation d'impédance RA1 comprend une première borne connectée à la première sortie du premier module de division MD1 et une seconde borne connectée au premier élément capacitif de liaison CA11. La seconde borne de l'élément capacitif CA11 est connectée à la première borne (cathode) C1 de la première diode D1. La seconde borne (anode) A1 de la première diode D1 est connectée au second élément capacitif de liaison CA12 qui est lui-même relié à la masse par sa seconde borne à travers le second circuit d'adaptation RA2. Des premier IC1 et second IC2 éléments inductifs de choc, connectés respectivement aux première C1 et seconde A1 bornes de la première diode D1, permettent de polariser la première diode D1 tout en coupant les signaux hyperfréquences vis-à-vis du circuit de polarisation P. A l'inverse, les premier CA11 et second CA12 éléments capacitifs de liaison permettent aux hyperfréquences de traverser la première diode D1 tout en bloquant les courants continus générés par l'auto-polarisation de la première diode D1 afin qu'ils passent exclusivement dans le circuit de polarisation P à travers les premiers IC1 et second IC2 éléments inductifs de choc. Les premier RA1 et second RA2 circuits d'adaptation servent quant à eux à adapter l'impédance présentée par la première diode D1 par rapport à l'impédance d'accès de la première sortie du premier module de division MD1.

Dans une variante de réalisation de la première voie V1, les premiers IC1 et second IC2 éléments inductifs de choc peuvent être remplacés par un circuit de polarisation à deux tronçons de ligne λ/4, comme illustré sur la figure 11.

On notera que lorsque le dispositif de transformation D constitue un linéariseur, la seconde voie V2 réalise la fonction de linéarisation. Elle se présente sous la forme d'un circuit micro-onde dont la fonction de transfert en transmission présente une expansion de gain et une variation de phase en fonction de sa puissance d'entrée grâce à l'utilisation des secondes diodes D2 en tant qu'impédance variable. Par conséquent, les secondes diodes D2 sont utilisées à la fois comme diodes intervenant dans le mécanisme d'auto-polarisation duale, mais également directement comme impédance variable non linéaire pour la fonction de linéarisation. L'auto-polarisation duale procure aux secondes diodes D2 un comportement singulier par rapport à un mécanisme d'auto-polarisation classique. En effet, la tension de commande continue VD2 montant avec la puissance d'entrée PSe, les secondes diodes D2 ont une impédance qui varie de façon particulière en fonction de la puissance d'entrée PSe (voir figure 8).

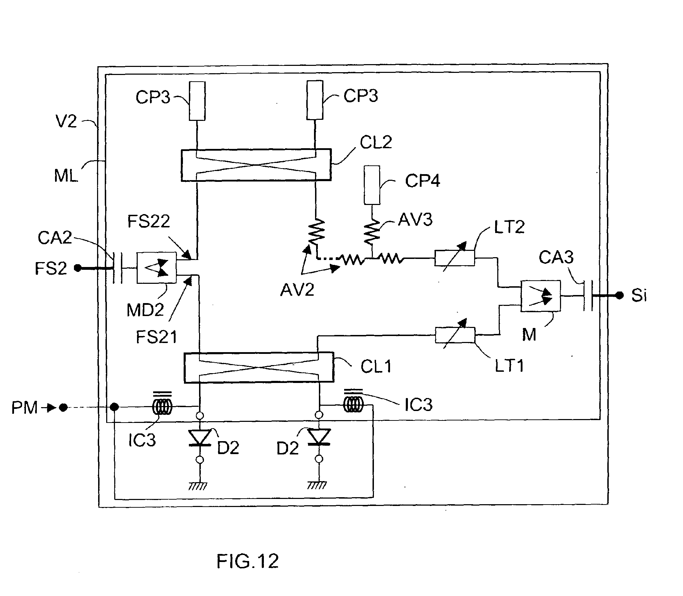

Sur la figure 12 se trouve illustré un second exemple de réalisation de la seconde voie V2 d'un dispositif de transformation D dédié à la linéarisation. Cette seconde voie assure ici une fonction de linéarisation dite « à recombinaison vectorielle », similaire à celle décrite dans le document brevet EP 1320190. Cet exemple de réalisation est particulièrement bien adapté aux applications requérant une large bande de fréquences.

Dans ce second exemple, les seconds moyens de connexion ML comprennent un premier élément capacitif de liaison CA2 (optionnel), un second module de division MD2, des première et seconde sous-voies, un module de combinaison MC, et un second élément capacitif de liaison CA3 (optionnel).

Le premier élément capacitif de liaison CA2 comprend une première borne connectée à la seconde sortie du premier module de division MD1 et une seconde borne connectée à l'entrée du second module de division MD2. Il est chargé de couper le courant continu qui est généré par l'auto-polarisation des secondes diodes D2, pour ne laisser passer que la seconde fraction FS2 du signal d'entrée Se.

Le second élément capacitif de liaison CA3 comprend une première borne connectée à la sortie du module de combinaison MC et une seconde borne définissant la borne de sortie de la seconde voie V2. Il est chargé de couper le courant continu qui est généré par l'auto-polarisation des secondes diodes D2, pour ne laisser passer que le signal hyperfréquence résultant du dispositif D.

Le second module de division MD2 est chargé de diviser (ou séparer) la seconde fraction FS2 du signal d'entrée Se, qu'il reçoit sur une entrée connectée à la seconde sortie du premier module de division MD1, en des première FS21 et seconde FS22 sous-fractions qu'il délivre respectivement sur des première et seconde sorties. Les valeurs complémentaires de ces première FS21 et seconde FS22 sous-fractions sont de préférence identiques (50%/50%). La première sortie du second module de division MD2 est connectée à la première sous-voie afin de l'alimenter avec la première sous-fraction FS21 du signal d'entrée Se. La seconde sortie du second module de division MD2 est connectée à la seconde sous-voie afin de l'alimenter avec la seconde sous-fraction FS22 du signal d'entrée Se.

Ce second module de division MD2 peut par exemple se présenter sous la forme d'un coupleur Wilkinson à 0° de type 1×2.

La première sous-voie (partie inférieure de la figure 12) est dite non-linéaire. Elle comprend deux éléments inductifs de choc IC4 (optionnels), un premier coupleur (de préférence de type coupleur de Lange) CL1, et une ligne de transmission LT1 de longueur réglable (optionnelle).

Le premier coupleur CL1 (de préférence un coupleur de Lange) comporte quatre accès. Des premier et second accès sont connectés chacun à la masse via une seconde diode D2 et sont polarisés par le générateur de tension continue G2 à travers la résistance R au point (noeud) milieu PM. Chaque seconde diode D2 se présente par exemple sous la forme d'une diode de type Schottky entre les bornes A (anode) et C (cathode) de laquelle circule un courant ID2. Les deux secondes diodes D2 sont de préférence identiques.

Dans l'exemple non limitatif illustré, l'anode A de chaque seconde diode D2 est connectée non seulement au premier ou second accès du premier coupleur de Lange CL1, mais également, du point de vue des courants et tensions continus, au point milieu PM via un élément inductif de choc IC4. Les éléments inductifs de choc IC4 sont chargés de couper les hyperfréquences, pour ne laisser passer que le continu. Ces éléments inductifs de choc IC4 peuvent se présenter sous la forme d'inductances ou de circuits de polarisation à deux tronçons de ligne λ/4 et peuvent être positionnés à différents endroits de la seconde voie V2 dans la mesure où ces éléments présentent une impédance élevée susceptible de bloquer les hyperfréquences (et donc ne perturbent pas le fonctionnement des circuits hyperfréquences) et où le courant continu peut alimenter les secondes diodes D2.

Le troisième accès du premier coupleur CL1 est connecté à la première sortie du second module de division MD2 (qui délivre la première sous-fraction FS21 du signal d'entrée Se).

Le quatrième accès du premier coupleur CL1 est connecté (directement ou indirectement) à la première entrée du module de combinaison MC. Dans l'exemple non limitatif illustré, cette connexion se fait via une ligne de transmission LT1 de longueur réglable de manière à permettre la modification du temps de propagation de groupe de la première sous-voie. Ainsi, on peut régler la phase de combinaison des signaux, issus des première et seconde sous-voies et qui alimentent le module de combinaison MC, de manière non uniforme en fonction de la fréquence.

La seconde sous-voie (partie supérieure de la figure 12) est dite linéaire. Elle comprend au moins deux composants passifs CP3 et un second coupleur (de préférence de type coupleur de Lange) CL2.

Le second coupleur CL2 comporte également quatre accès. Des premier et second accès sont connectés chacun à la masse via un composant passif CP3. Chaque composant passif est par exemple un tronçon de ligne de transmission hyperfréquence en circuit ouvert et de longueur et largeur ajustables (ou stub). Grâce à de tels stubs à longueur et largeur ajustables, on peut faire varier la phase des signaux hyperfréquences de la seconde sous-fraction FS22 de manière uniforme en fonction de la fréquence.

Le troisième accès du second coupleur CL2 est connecté à la seconde sortie du second module de division MD2 (qui délivre la seconde sous-fraction FS22 du signal d'entrée Se).

Le quatrième accès du second coupleur CL2 est connecté de préférence indirectement à la seconde entrée du module de combinaison MC. Dans l'exemple non limitatif illustré, cette connexion se fait via des atténuateurs variables AV2 et AV3 et une ligne de transmission LT2 de longueur réglable montés en série.

Les atténuateurs variables AV2 sont par exemple constitués d'éléments résistifs répartis en série ou en parallèle, préférentiellement le long de la seconde sous-voie, et pouvant être court-circuités ou non par un ruban ou un fil métallique de façon à faire varier leur atténuation de 0dB à 0.5dB, voire quelques dB, par exemple.

Les atténuateurs variables AV3 sont par exemple constitués d'éléments résistifs répartis en parallèle, préférentiellement le long de la seconde sous-voie, et pouvant être connectés ou non par un ruban ou un fil métallique à la ligne de transmission de la seconde sous-voie de façon à faire varier leur atténuation de 0dB à 0.5dB, voire quelques dB, par exemple. La mise à la masse de l'élément résistif AV3 est alors réalisée par un tronçon de ligne de transmission CP4 de type stub de longueur λ/4 et terminé par un circuit ouvert.

La ligne de transmission LT2 permet de modifier le temps de propagation de groupe de la seconde sous-voie. Ainsi, on peut régler la phase de combinaison des signaux, issus des première et seconde sous-voies et qui alimentent le module de combinaison MC, de manière non uniforme en fonction de la fréquence.

On notera qu'il n'est pas obligatoire que les deux sous-voies comprennent toutes les deux une ligne de transmission LT1 ou LT2 de longueur réglable. L'une seulement d'entre elles peut en effet être équipée d'une ligne de transmission de ce type. Ces lignes de transmission LT1 et/ou LT2 peuvent permettre aux première et seconde sous-voies de présenter le même temps de propagation de groupe. Ainsi, la phase de recombinaison des première et seconde sous-voies peut être constante sur toute une bande de fréquences, si bien que la réponse du linéariseur D est constante sur cette même bande. A l'inverse, les lignes de transmission LT1 et/ou LT2 peuvent permettre aux première et seconde sous-voies de présenter volontairement un temps de propagation de groupe différent. Il est rappelé que, dans ce cas, la phase de recombinaison entre les première et seconde sous-voies est alors une fonction linéaire de la fréquence dans la bande utile du linéariseur D, dont la pente est déterminée par les longueurs des lignes de transmission LT1 et LT2. Ce réglage de phase de recombinaison différent suivant la fréquence est dans ce cas utilisé pour conférer au linéariseur D un comportement non uniforme en fonction de la fréquence, à même de compenser la variation de la compression de gain et de phase de l'amplificateur de puissance AP, AP' en fonction de la fréquence. Les amplificateurs à tube à onde progressive ou TWTAs (pour « Travelling Wave Tube Amplifiers ») présentent en effet des variations significatives de leurs compressions de gain et de phase sur les bandes de fréquences utilisées classiquement sur les charges utiles de satellite, par exemple.

Les premier CL1 et second CL2 coupleurs (de Lange) sont de préférence identiques afin d'assurer par construction un même temps de propagation de groupe pour les première et seconde sous-voies.

Le module de combinaison MC est chargé de combiner les signaux hyperfréquences traités et délivrés par les première et seconde sous-voies afin de constituer le signal intermédiaire Si. Il peut par exemple se présenter sous la forme d'un coupleur Wilkinson à 0° de type 2×1.

Bien entendu, le dispositif de transformation D peut comporter d'autres modes de réalisation de premiers MF et/ou seconds ML moyens de connexion que ceux décrits ci-avant en référence aux figures 10 à 12.

Le dispositif de transformation D selon l'invention et/ou le dispositif d'amplification AP ou AP' selon l'invention, peu(ven)t être réalisé(s) sous la forme de circuits électroniques, éventuellement intégrés.

L'invention ne se limite pas aux modes de réalisation de dispositif de transformation et de dispositif d'amplification décrits ci-avant, seulement à titre d'exemple, mais elle englobe toutes les variantes que pourra envisager l'homme de l'art dans le cadre des revendications ci-après.

## Revendications

1. Dispositif (D) de linéarisation à pré-distortion à expansions de gain et de phase pour la compensation de la compression de gain et de la variation de phase d'un amplificateur de puissance (AP, AP'), **caractérisé en ce qu'**il comprend :
- des premiers moyens de division (MD1) comprenant une entrée (Se) propre à recevoir un signal d'entrée hyperfréquence et des première et seconde sorties agencées pour délivrer des première et seconde fractions choisies dudit signal d'entrée,
- une première voie (V1) connectée à ladite première sortie afin d'être alimentée par ladite première fraction du signal d'entrée (Se), et agencée pour générer un premier courant continu à partir d'une première auto-polarisation d'une première diode (D1) en fonction de ladite première fraction du signal d'entrée (Se),
- une seconde voie (V2) connectée à ladite seconde sortie afin d'être alimentée par ladite seconde fraction du signal d'entrée (Se), et agencée pour réaliser des expansions de gain et de phase au niveau d'un accès (Si) constituant une sortie à partir d'une seconde auto-polarisation d'au moins une seconde diode (D2) en fonction de la seconde fraction du signal d'entrée (Se), et
- un circuit de polarisation (P) connecté aux, et alimentant en tensions continues, lesdites première (V1) et seconde (V2) voies, et agencé pour combiner, de manière antagoniste, les tensions et courants continus issus des première et seconde auto-polarisations des première (V1) et seconde (V2) voies de manière à contrôler le galbe des expansions de gain et de phase de la seconde voie (V2) en fonction de l'amplitude du signal d'entrée (Se).

2. Dispositif selon la revendication 1, **caractérisé en ce que** ladite première voie (V1) comprend un premier circuit (MF) connecté à ladite première sortie des premiers moyens de division (MD1) et agencé pour alimenter au moins une première diode (D1) avec la première fraction dudit signal d'entrée (Se) et pour fournir deux accès (VD1A, VD1C) isolés vis-à-vis de ladite première fraction du signal d'entrée (Se) et permettant d'appliquer directement des tensions continues respectivement aux bornes (A1, C1) de ladite première diode (D1).

3. Dispositif selon l'une des revendications 1 et 2, **caractérisé en ce que** ladite seconde voie (V2) comprend un second circuit (ML) connecté à ladite seconde sortie des premiers moyens de division (MD1) et agencé pour alimenter au moins une seconde diode (D2) avec une partie au moins de ladite seconde fraction dudit signal d'entrée (Se) afin de transformer une variation d'impédance de ladite seconde diode (D2) en fonction de ladite seconde fraction du signal d'entrée (Se) en expansions de gain et de phase au niveau d'un accès (Si) définissant une sortie, et pour fournir deux autres accès (VD2A, VD2C) isolés vis-à-vis de ladite seconde fraction du signal d'entrée (Se) et permettant d'appliquer directement des tensions continues respectivement aux bornes (A2, C2) de ladite seconde diode (D2).

4. Dispositif selon l'une des revendications 2 et 3, **caractérisé en ce que** ledit circuit de polarisation (P) comprend un premier générateur de tension continue (G1) connecté à l'une (A1) des bornes de ladite première diode (D1) à travers ledit accès (VD1A), un second générateur de tension continue (G2) connecté simultanément à travers une résistance (R) à un noeud commun (PM) constitué de l'autre (C1) des bornes de ladite première diode (D1) à travers l'un (VD1C) desdits accès de la première voie (V1) et de l'une (A2) des bornes de ladite seconde diode (D2) à travers l'un (VD2A) desdits accès de la seconde voie (V2), l'autre (C2) desdites bornes de ladite seconde diode (D2) étant reliée, à travers l'autre (VD2C) desdits accès de la seconde voie (V2), à la masse du point de vue de la tension continue.

5. Dispositif selon l'une des revendications 1 à 4, **caractérisé en ce que** le sens desdites première diode (D1) et seconde diode (D2) peut être simultanément inversé.

6. Dispositif selon l'une des revendications 1 à 5, **caractérisé en ce que** lesdits premiers moyens de division (MD1) comprennent un coupleur (CP) agencé pour diviser la puissance dudit signal d'entrée (Se) en deux parties, et un élément (AV1) placé en aval de l'une au moins des deux sorties du coupleur (CP) et chargé d'amplifier ou d'atténuer d'une quantité choisie et réglable la valeur de la puissance délivrée par chacune des deux sorties dudit coupleur (CP), de sorte que lesdits premiers moyens de division (MD1) délivrent sur des première et seconde sorties respectivement lesdites première et seconde fractions choisies, ajustables, dudit signal d'entrée (Se).

7. Dispositif selon la revendication 6, **caractérisé en ce que** ledit élément (AV1) est choisi dans un groupe comprenant un élément atténuateur variable, un élément amplificateur, un élément amplificateur à gain variable, et un élément associant en cascade plusieurs des fonctions des autres éléments dudit groupe.

8. Dispositif selon l'une des revendications 6 et 7, **caractérisé en ce que** ledit élément (AV1) présente un comportement non uniforme et réglable en fonction de la fréquence.

9. Dispositif selon l'une des revendications 3 à 8, **caractérisé en ce que** ledit second circuit (ML) constitue un circuit de linéarisation à base de diode(s) dont les accès de polarisation continue ne comportent pas de résistance en série avec ladite ou lesdites diodes.

10. Dispositif selon la revendication 9, **caractérisé en ce que** ledit circuit de linéarisation (ML) comprend :
- des seconds moyens de division (MD2) comprenant une entrée connectée à ladite seconde sortie des premiers moyens de division (MD1) et des première et seconde sorties agencées pour délivrer des première et seconde sous-fractions choisies de ladite seconde fraction du signal d'entrée,
- des moyens de combinaison (MC) comprenant des première et seconde entrées et une sortie propre à délivrer des signaux de sortie résultant de la combinaison des signaux reçus sur ses première et seconde entrées,
- une première sous-voie dite non linéaire comportant un premier coupleur (CL1) comprenant des premier et deuxième accès connectés chacun à la masse via au moins une seconde diode (D2) alimentée en tension et courant continus par le second générateur (G2) à travers la résistance (R) au noeud (PM), un troisième accès connecté à la première sortie des seconds moyens de division (MD2), et un quatrième accès couplé à ladite première entrée des moyens de combinaison (MC), et
- une seconde sous-voie dite linéaire comportant un second coupleur (CL2) sensiblement identique audit premier coupleur (CL1) afin d'assurer par construction un même temps de propagation de groupe pour lesdites première et seconde sous-voies et comprenant des premier et deuxième accès connectés chacun à la masse via des troisièmes composants passifs (CP3), un troisième accès connecté à la seconde sortie des seconds moyens de division (MD2), et un quatrième accès couplé à ladite seconde entrée des moyens de combinaison (MC).

11. Dispositif selon la revendication 10, **caractérisé en ce que** lesdits troisièmes composants passifs (CP3) sont des tronçons de ligne de transmission hyperfréquence en circuit ouvert, de longueur et largeur ajustables de manière à ajuster la phase de combinaison des signaux dans lesdits moyens de combinaison (MC), de façon sensiblement constante sur toute une bande de fréquences choisie.

12. Dispositif selon l'une des revendications 10 et 11, **caractérisé en ce que** l'une au moins desdites première et seconde sous-voies comporte une ligne de transmission (LT1, LT2) de longueur réglable, de manière à modifier le temps de propagation de groupe de sa sous-voie pour régler la phase de combinaison des signaux dans lesdits moyens de combinaison (MC), de façon non constante en fonction de la fréquence, de sorte que ledit linéariseur (D) présente un comportement différent en fonction de la fréquence sur une large bande de fréquences de manière à suivre des variations fréquentielles de l'amplificateur de puissance (AP, AP') à linéariser.

13. Dispositif selon l'une des revendications 10 à 12, **caractérisé en ce que** l'une au moins desdites première et seconde sous-voies comporte au moins une résistance gravée en série ou en parallèle sur la ligne de transmission jouant le rôle d'atténuateur de valeur d'atténuation réglable entre une valeur finie et zéro par court-circuit de ladite résistance en série au moyen d'un ruban ou d'au moins un fil métallique et par rupture du ou des rubans ou fils de connexion reliant ladite résistance en parallèle, à la ligne de transmission.

14. Dispositif selon l'une des revendications 2 à 13, **caractérisé en ce que** ledit premier circuit (MF) comprend des éléments de circuit agencés pour adapter l'impédance de ladite première diode (D1) par rapport à ladite première sortie des premiers moyens de division (MD1) et pour permettre la polarisation des bornes (A1, C1) de ladite première diode (D1) sans résistance en série sur l'une ou l'autre de ces bornes (A1, C1).

15. Dispositif selon l'une des revendications 2 à 14, **caractérisé en ce que** ledit premier circuit (MF) comprend des circuits de polarisation en quart de longueur d'onde comportant une première ligne de transmission d'impédance caractéristique élevée, de longueur égale au quart de la longueur d'onde, dont une première extrémité est connectée à la ligne alimentant ladite première diode (D1) et une seconde extrémité est connectée, d'une part, à une seconde ligne de transmission d'impédance caractéristique faible, de longueur égale au quart de la longueur d'onde, et terminée par un circuit ouvert, et d'autre part, à l'un des accès de polarisation (VD1A, VD1C) dudit premier circuit (MF).

16. Dispositif selon l'une des revendications 2 à 15, **caractérisé en ce que** ledit premier circuit (MF) comprend plusieurs circuits de polarisation en quart de longueur d'onde cascadés de manière à augmenter l'isolation des accès de polarisation (VD1A, VD1C) dudit premier circuit (MF) par rapport à la première fraction dudit signal d'entrée (Se).

17. Dispositif d'amplification de puissance à état solide (AP'), **caractérisé en ce qu'**il comprend un dispositif de linéarisation à pré-distortion (D) selon l'une des revendications précédentes.

## Claims

1. Pre-distortion linearisation device (D) with gain and phase expansions for compensating for the gain compression and phase variation of a power amplifier (AP, AP'), **characterised in that** it comprises:
- first division means (MD1) which comprise an input (Se) which is capable of receiving a hyperfrequency input signal and first and second outputs which are provided to supply first and second fractions selected from the input signal,
- a first path (V1) which is connected to the first output in order to be supplied by the first fraction of the input signal (Se) and which is provided to generate a first direct current from a first self-polarisation of a first diode (D1) in accordance with the first fraction of the input signal (Se),
- a second path (V2) which is connected to the second output in order to be supplied by the second fraction of the input signal (Se) and which is provided to bring about gain and phase expansions at the level of an access (Si) which constitutes an output from a second self-polarisation of at least a second diode (D2) in accordance with the second fraction of the input signal (Se) and
- a polarisation circuit (P) which is connected to and which supplies direct-current voltages to the first (V1) and second (V2) paths and which is provided to combine in an antagonistic manner the direct currents and voltages from the first and second self-polarisation operations of the first (V1) and second (V2) paths in order to control the form of the gain and phase expansions of the second path (V2) in accordance with the amplitude of the input signal (Se).

2. Device according to claim 1, **characterised in that** the first path (V1) comprises a first circuit (MF) which is connected to the first output of the first division means (MD1) and which is provided in order to supply at least a first diode (D1) with the first fraction of the input signal (Se) and in order to provide two accesses (VD1A, VD1C) which are isolated with respect to the first fraction of the input signal (Se) and which allow direct application of the direct-current voltages to the terminals (A1, C1) of the first diode (D1), respectively.

3. Device according to either claim 1 or claim 2, **characterised in that** the second path (V2) comprises a second circuit (ML) which is connected to the second output of the first division means (MD1) and which is provided in order to supply at least a second diode (D2) with at least a portion of the second fraction of the input signal (Se) in order to convert an impedance variation of the second diode (D2) in accordance with the second fraction of the input signal (Se) into gain and phase expansions at the level of an access (Si) which defines an output, and in order to provide two other accesses (VD2A, VD2C) which are isolated with respect to the second fraction of the input signal (Se) and which allow direct application of the direct-current voltages to the terminals (A2, C2) of the second diode (D2), respectively.

4. Device according to either claim 2 or claim 3, **characterised in that** the polarisation circuit (P) comprises a first direct-current voltage generator (G1) which is connected to one (A1) of the terminals of the first diode (D1) via the access (VD1A), a second direct-current voltage generator (G2) which is simultaneously connected via a resistor (R) to a common node (PM) which is constituted by the other one (C1) of the terminals of the first diode (D1) via one (VD1C) of the accesses of the first path (V1) and one (A2) of the terminals of the second diode (D2) via one (VD2A) of the accesses of the second path (V2), the other (C2) of the terminals of the second diode (D2) being connected, via the other (VD2C) of the accesses of the second path (V2), to earth in respect of the direct-current voltage.

5. Device according to any one of claims 1 to 4, **characterised in that** the direction of the first diode (D1) and second diode (D2) may be inverted simultaneously.

6. Device according to any one of claims 1 to 5, **characterised in that** the first division means (MD1) comprise a coupler (CP) which is provided in order to divide the power of the input signal (Se) into two portions and an element (AV1) which is positioned downstream of at least one of the two outputs of the coupler (CP) and which is responsible for amplifying or attenuating by a selected and adjustable quantity the value of the power supplied by each of the two outputs of the coupler (CP) so that the first division means (MD1) supply the first and second selected adjustable fractions of the input signal (Se) at first and second outputs, respectively.

7. Device according to claim 6, **characterised in that** the element (AV1) is selected from a group comprising a variable attenuation element, an amplification element, a variable gain amplification element and an element associating in a cascade-like manner a plurality of the functions of the other elements of the group.

8. Device according to either claim 6 or claim 7, **characterised in that** the element (AV1) has non-uniform behaviour which is adjustable in accordance with the frequency.

9. Device according to any one of claims 3 to 8, **characterised in that** the second circuit (ML) constitutes a linearisation circuit based on diode(s) whose continuous polarisation accesses do not comprise a series resistor with the diode(s).

10. Device according to claim 9, **characterised in that** the linearisation circuit (ML) comprises:
- second division means (MD2) which comprise an input connected to the second output of the first division means (MD1) and the first and second outputs which are provided in order to supply first and second sub-fractions selected from the second fraction of the input signal,
- combination means (MC) which comprise first and second inputs and an output capable of supplying output signals resulting from the combination of the signals received at the first and second inputs thereof,
- a first sub-path, referred to as a non-linear sub-path, which comprises a first coupler (CL1) which comprises first and second accesses which are each connected to earth via at least a second diode (D2) which is supplied with direct-current voltage and direct current by the second generator (G2) via the resistor (R) at the node (PM), a third access which is connected to the first output of the second division means (MD2) and a fourth access which is coupled to the first input of the combination means (MC), and
- a second sub-path, which is referred to as a linear sub-path, comprising a second coupler (CL2) which is substantially identical to the first coupler (CL1) in order to ensure by construction an identical group propagation time for the first and second sub-paths and comprising first and second accesses which are each connected to earth via third passive components (CP3), a third access which is connected to the second output of the second division means (MD2) and a fourth access which is coupled to the second input of the combination means (MC).

11. Device according to claim 10, **characterised in that** the third passive components (CP3) are open-circuit hyperfrequency transmission line portions having a length and width which are adjustable so as to adjust the combination phase of the signals in the combination means (MC) in a substantially constant manner over an entire frequency band selected.

12. Device according to either claim 10 or claim 11, **characterised in that** at least one of the first and second sub-paths comprises(s) a transmission line (LT1, LT2) of adjustable length so as to modify the group propagation time of the sub-path thereof in order to adjust the combination phase of the signals in the combination means (MC) in a non-constant manner in accordance with the frequency so that the lineariser (D) has a different behaviour in accordance with the frequency over a wide band of frequencies so as to follow frequency variations of the power amplifier (AP, AP') to be linearised.

13. Device according to any one of claims 10 to 12, **characterised in that** at least one of the first and second sub-paths comprise(s) at least one resistor etched in series or in parallel on the transmission line, acting as an attenuator of an attenuation value adjustable between a finite value and zero by short-circuiting the series resistor by means of a strip or at least one metal wire and, by breaking the strip(s) or connection wire(s), connecting the parallel resistor to the transmission line.

14. Device according to any one of claims 2 to 13, **characterised in that** the first circuit (MF) comprises circuit elements which are provided in order to adapt the impedance of the first diode (D1) relative to the first output of the first division means (MD1) and in order to allow the polarisation of the terminals (A1, C1) of the first diode (D1) without a series resistor at one or other of those terminals (A1, C1).

15. Device according to any one of claims 2 to 14, **characterised in that** the first circuit (MF) comprises circuits for polarisation at a quarter of a wavelength comprising a first characteristic high impedance transmission line having a length equal to one quarter of the wavelength, of which a first end is connected to the line supplying the first diode (D1) and a second end is connected, on the one hand, to a second characteristic low impedance transmission line, having a length equal to one quarter of the wavelength, and is terminated by an open circuit, and, on the other hand, to one of the polarisation accesses (VD1A, VD1C) of the first circuit (MF).

16. Device according to any one of claims 2 to 15, **characterised in that** the first circuit (MF) comprises a plurality of circuits for polarisation at a quarter of a wavelength which are cascaded so as to increase the isolation of the polarisation accesses (VD1A, VD1C) of the first circuit (MF) relative to the first fraction of the input signal (Se).

17. Device for solid-state power amplification (AP'), **characterised in that** it comprises a pre-distortion linearisation device (D) according to any one of the preceding claims.

## Patentansprüche

1. Vorrichtung (D) zur Vorverzerrung-Linearisierung mit Verstärkungs- und Phasenexpansionen für die Kompensation der Verstärkungskompression und der Phasenänderung eines Leistungsverstärkers (AP, AP'), **dadurch gekennzeichnet, dass** sie umfasst:
- erste Teilermittel (MD1), die einen Eingang (Se) umfassen, der imstande ist, ein Hyperfrequenz-Eingangssignal zu empfangen, und einen ersten und zweiten Ausgang, die ausgebildet sind, um eine ausgewählte erste und zweite Fraktion des Eingangssignals bereitzustellen,
- einen ersten Kanal (V1), der an den ersten Ausgang gekoppelt ist, um von der ersten Fraktion des Eingangssignals (Se) versorgt zu sein, und ausgebildet, um ausgehend von einer ersten Selbstpolarisierung einer ersten Diode (D1) in Abhängigkeit von der ersten Fraktion des Eingangssignals (Se) einen ersten Gleichstrom zu erzeugen,
- einen zweiten Kanal (V2), der an den zweiten Ausgang gekoppelt ist, um von der zweiten Fraktion des Eingangssignals (Se) versorgt zu sein, und ausgebildet, um ausgehend von einer zweiten Selbstpolarisierung mindestens einer zweiten Diode (D2) in Abhängigkeit von der zweiten Fraktion des Eingangssignals (Se) Verstärkungs- und Phasenexpansionen auf Ebene eines Zugangs (Si), der einen Ausgang bildet, durchzuführen,
- einen Polarisierungskreis (P), der an den ersten (V1) und zweiten (V2) Kanal gekoppelt ist und mit Gleichspannungen versorgt, und ausgebildet, um antagonistisch die Gleichströme und -spannungen, die von der ersten und zweiten Selbstpolarisierung des ersten (V1) und zweiten (V2) Kanals ausgehen, derart zu kombinieren, dass die Form der Verstärkungs- und Phasenexpansionen des zweiten Kanals (V2) in Abhängigkeit von der Amplitude des Eingangssignals (Se) kontrolliert werden.

2. Vorrichtung nach Anspruch 1, **dadurch gekennzeichnet, dass** der erste Kanal (V1) einen ersten Kreis (MF) umfasst, der an den ersten Ausgang der ersten Teilermittel (MD1) gekoppelt ist und ausgebildet, um mindestens eine erste Diode (D1) mit der ersten Fraktion des Eingangssignals (Se) zu versorgen und um gegenüber der ersten Fraktion des Eingangssignals (Se) zwei einzelne Zugänge (VD1A, VD1C) bereitzustellen und zu erlauben, Gleichspannungen jeweils an die Klemmen (A1, C1) der ersten Diode (D1) direkt anzulegen.

3. Vorrichtung nach einem der Ansprüche 1 und 2, **dadurch gekennzeichnet, dass** der zweite Kanal (V2) einen zweiten Kreis (ML) umfasst, der an den zweiten Ausgang der ersten Teilermittel (MD1) gekoppelt ist und ausgebildet, um mindestens eine zweite Diode (D2) mit mindestens einem Teil der zweiten Fraktion des Eingangssignals (Se) zu versorgen, um eine Impedanzvariation der zweiten Diode (D2) in Abhängigkeit von der zweiten Fraktion des Eingangssignals (Se) in Verstärkungs- und Phasenexpansionen auf Ebene eines Zugangs (Si), der einen Ausgang definiert, umzuformen, und um gegenüber der zweiten Fraktion des Eingangssignals (Se) zwei andere einzelne Zugänge (VD2A, VD2C) bereitzustellen und zu erlauben, Gleichspannungen jeweils an die Klemmen (A2, C2) der zweiten Diode (D2) direkt anzulegen.

4. Vorrichtung nach einem der Ansprüche 2 und 3, **dadurch gekennzeichnet, dass** der Polarisierungskreis (P) einen ersten Gleichspannungsgenerator (G1) umfasst, der über den Zugang (VD1A) an eine (A1) der Klemmen der ersten Diode (D1) gekoppelt ist, einen zweiten Gleichspannungsgenerator (G2), der gleichzeitig über einen Widerstand (R) an einen gemeinsamen Knoten (PM) gekoppelt ist, der von der anderen (C1) der Klemmen der ersten Diode (D1) über einen (VD1C) der Zugänge des ersten Kanal (V1) und von einer (A2) der Klemmen der zweiten Diode (D2) über einen (VD2A) der Zugänge des zweiten Kanals (V2) gebildet wird, wobei die andere (C2) der Klemmen der zweiten Diode (D2) über den anderen (VD2C) der Zugänge des zweiten Kanal (V2) im Hinblick auf die Gleichspannung mit der Masse verbunden ist.

5. Vorrichtung nach einem der Ansprüche 1 bis 4, **dadurch gekennzeichnet, dass** die Richtung der ersten Diode (D1) und zweiten Diode (D2) gleichzeitig umgedreht sein kann.

6. Vorrichtung nach einem der Ansprüche 1 bis 5, **dadurch gekennzeichnet, dass** die ersten Teilermittel (MD1) einen Koppler (CP) umfassen, der ausgebildet ist, um die Leistung des Eingangssignal (Se) in zwei Teile zu teilen, und ein Element (AV1), das nach mindestens einem der zwei Ausgänge des Kopplers (CP) platziert ist und beauftragt, den Wert der von jedem der zwei Ausgänge des Kopplers (CP) bereitgestellten Leistung derart zu verstärken oder zu dämpfen, dass die ersten Teilermittel (MD1) über den ersten und zweiten Ausgang jeweils die ausgewählte erste und zweite regulierbare Fraktion des Eingangssignals (Se) bereitstellen.

7. Vorrichtung nach Anspruch 6, **dadurch gekennzeichnet, dass** das Element (AV1) aus einer Gruppe ausgewählt ist, die ein variables Dämpfungselement, ein Verstärkungselement, ein Verstärkungselement mit variabler Verstärkung und ein Element umfasst, dass mehrere Funktionen der anderen Elemente der Gruppe als Kaskade kombiniert.

8. Vorrichtung nach einem der Ansprüche 6 und 7, **dadurch gekennzeichnet, dass** das Element (AV1) ein nicht einheitliches und in Abhängigkeit von der Frequenz einstellbares Verhalten aufweist.

9. Vorrichtung nach einem der Ansprüche 3 bis 8, **dadurch gekennzeichnet, dass** der zweite Kreis (ML) einen Linearisierungskreis auf Diodenbasis darstellt, dessen Gleichstromvorspannungszugänge keinen Widerstand in Reihe mit der oder den Dioden aufweisen.

10. Vorrichtung nach Anspruch 9, **dadurch gekennzeichnet, dass** der Linearisierungskreis (ML) umfasst:
- zweite Teilermittel (MD2), die einen Eingang umfassen, der an den zweiten Ausgang der ersten Teilermittel (MD1) gekoppelt ist und einen ersten und zweiten Ausgang, die ausgebildet sind, um ausgewählte erste und zweite Unter-Fraktionen der zweiten Fraktion des Eingangssignals bereitzustellen,
- Kombinationsmittel (MC), die einen ersten und zweiten Eingang umfassen und einen Ausgang, der imstande ist, Ausgangssignale bereitzustellen, die aus der Kombination der über seinen ersten und zweiten Eingang empfangenen Signale resultieren,
- einen ersten so genannten nicht linearen Unterkanal, der einen ersten Koppler (CL1) aufweist, der einen ersten und zweiten Zugang aufweist, die jeweils an die Masse über mindestens eine zweite Diode (D2) gekoppelt sind, die von dem zweiten Generator (G2) über den Widerstand (R) am Knoten (PM) mit Gleichspannung und -strom versorgt wird, einen dritten Zugang, der an den ersten Ausgang der zweiten Teilermittel (MD2) gekoppelt ist und einen vierten Zugang, der an den ersten Eingang der Kombinationsmittel (MC) gekoppelt ist, und
- einen zweiten so genannten linearen Unterkanal, der einen zweiten Koppler (CL2) aufweist, der mit dem ersten Koppler (CL1) etwa identisch ist, um durch Konstruktion eine gleich Gruppenübertragungszeit für den ersten und zweiten Unterkanal zu gewährleisten und einen ersten und zweiten Zugang umfasst, die jeweils an die Masse über dritte passive Komponenten (CP3) gekoppelt sind, einen dritten Zugang, der an den zweiten Ausgang der zweiten Teilermittel (MD2) gekoppelt ist und einen vierten Zugang, der an den zweiten Eingang der Kombinationsmittel (MC) gekoppelt ist.

11. Vorrichtung nach Anspruch 10, **dadurch gekennzeichnet, dass** die dritten passiven Komponenten (CP3) Abschnitte von Hyperfrequenz-Übertragungsleitungen in offenem Kreis, mit derart einstellbarer Länge und Breite sind, um die Signal-Kombinationsphase in den Kombinationsmitteln (MC) über ein gesamtes ausgewähltes Frequenzband etwa konstant einzustellen.

12. Vorrichtung nach einem der Ansprüche 10 und 11, **dadurch gekennzeichnet, dass** mindestens einer des ersten und zweiten Unterkanals eine Übertragungsleitung (LT1, LT2) einstellbarer Länge aufweist, um die Gruppen-Übertragungszeit seines Unterkanals zu verändern, um die Signal-Kombinationsphase in dem Kombinationsmitteln (MC) in Abhängigkeit von der Frequenz derart nicht konstant einzustellen, dass der Linearisierer (D) in Abhängigkeit von der Frequenz über ein breites Frequenzband ein unterschiedliches Verhalten aufweist, um Frequenzvariationen des zu linearisierenden Leistungsverstärkers (AP, AP') zu folgen.

13. Vorrichtung nach einem der Ansprüche 10 bis 12, **dadurch gekennzeichnet, dass** mindestens einer des ersten und zweiten Unterkanals mindestens einen in Reihe oder parallel auf der Übertragungsleitung geprägten Widerstand aufweist, der die Rolle eines Dämpfers des Dämpfungswerts spielt, der zwischen einem Endwert und Null durch Kurzschluss des Widerstands in Reihe mittels eines Bands oder mindestens eines Metalldrahts und durch Bruch des oder der Bänder oder Verbindungsdrähte, die den Widerstand mit der Übertragungsleitung parallel verbinden, einstellbar ist.

14. Vorrichtung nach einem der Ansprüche 2 bis 13, **dadurch gekennzeichnet, dass** der erste Kreis (MF) Kreiselemente umfasst, die ausgebildet sind, um die Impedanz der ersten Diode (D1) im Verhältnis zum ersten Ausgang der ersten Teilermittel (MD1) anzupassen und um die Polarisierung der Klemmen (A1, C1) der ersten Diode (D1) ohne Widerstand in Reihe auf der einen oder der anderen dieser Klemmen (A1, C1) zu erlauben.

15. Vorrichtung nach einem der Ansprüche 2 bis 14, **dadurch gekennzeichnet, dass** der erste Kreis (MF) Polarisierungskreise in Viertelwellenlänge umfasst, die eine erste Impedanzübertragungsleitung höherer Kennlinie aufweisen mit einer Länge, die dem Viertel der Wellenlänge entspricht, von der ein erstes Ende an die Leitung gekoppelt ist, die die erste Diode (D1) versorgt, und ein zweites Ende einerseits an eine zweite Impedanzübertragungsleitung schwacher Kennlinie mit einer Länge, die gleich dem Viertel der Wellenlänge ist, gekoppelt ist, und von einem offenen Kreis beendet wird, und andererseits an einen der Polarisierungszugänge (VD1A, VD1C) des ersten Kreises (MF).

16. Vorrichtung nach einem der Ansprüche 2 bis 15, **dadurch gekennzeichnet, dass** der erste Kreis (MF) mehrere Polarisierungskreise in Viertelwellenlänge umfasst, die derart kaskadiert sind, dass die Isolierung der Polarisierungszugänge (VD1A, VD1C) des ersten Kreises (MF) im Verhältnis zur ersten Fraktion des Eingangssignals (Se) verstärkt wird.

17. Leistungsverstärkungsvorrichtung in festem Zustand (AP'), **dadurch gekennzeichnet, dass** sie eine Vorrichtung (D) zur Vorverzerrung-Linearisierung nach einem der vorangehenden Ansprüche umfasst.
